Europäisches Patentamt

European Patent Office

Office européen des brevets

(11) Veröffentlichungsnummer: **0 180 001**
**A2**

## EUROPÄISCHE PATENTANMELDUNG

(21) Anmeldenummer: 85110887.8

(22) Anmeldetag: 29.08.85

(51) Int. Cl.⁴: **G11C 11/34**

(30) Priorität: 28.09.84 DE 3435752

(43) Veröffentlichungstag der Anmeldung:
07.05.86 Patentblatt 86/19

(84) Benannte Vertragsstaaten:
DE FR GB IT

(71) Anmelder: **Siemens Aktiengesellschaft**
**Berlin und München Wittelsbacherplatz 2**
**D-8000 München 2(DE)**

(72) Erfinder: **Mattausch, Hans-Jürgen, Dr.**
**Am Brunnen 26**
**D-8011 Kirchheim(DE)**

(54) Schaltung zur Zwischenspeicherung digitaler Signale.

(57) Schaltung zur Zwischenspeicherung digitaler Signale in komplementärer integrierter Schaltungstechnik. Angestrebt wird eine Ausbildung der Schaltung, die große Kennwertetoleranzen und damit eine Realisierung auf einer relativ kleinen Halbleiterfläche erlaubt, ohne daß an die geometrische Form dieser Fläche besondere Anforderungen gestellt zu werden brauchen. Erreicht wird dies dadurch, daß ein Schaltungseingang (E) über die Serienschaltung eines Feldeffekttransistors (T1) des ersten Kanaltyps und zweier Inverter (I1, I2) mit einem Schaltungsknoten (Z) verbunden ist, daß beide Inverter (I1, I2) mit einem gemeinsamen Rückkopplungszweig (1) versehen sind, der einen Feldeffekttransistor (T2) des zweiten Kanaltyps enthält, und daß die Gateelektroden beider Feldeffekttransistoren (T1, T2) mit einem gemeinsamen Taktspannungsanschluß (TA) beschaltet sind. Eine Erweiterung der Schaltung sieht vor, daß eine gleichartig aufgebaute Schaltung (T3, T4, I3, I4), bei der lediglich die Kanaltypen beider Feldeffekttransistoren (T3, T4) miteinander vertauscht sind, angefügt wird, wobei der Schaltungseingang dieser weiteren Schaltung an den Schaltungsknoten (Z) gelegt ist. Der Anwendungsbereich umfaßt Schaltungen zur digitalen Signalverarbeitung, insbesondere zur Filterung von Fernsehsignalen.

## FIG 1

EP 0 180 001 A2

Schaltung zur Zwischenspeicherung digitaler Signale

Die Erfindung bezieht sich auf eine Schaltung zur Zwischenspeicherung digitaler Signale in komplementärer integrierter Schaltungstechnik.

Es liegt ihr die Aufgabe zugrunde, eine Schaltung dieser Art anzugeben, die bei einfachem Aufbau auf einer kleinen Halbleiterfläche realisiert werden kann, ohne daß an die geometrische Form dieser Fläche besondere Anforderungen gestellt werden müssen. Das wird erfindungsgemäß durch eine Ausbildung der Schaltung nach dem kennzeichnenden Teil des Patentanspruchs 1 erreicht.

Der mit der Erfindung erzielbare Vorteil liegt insbesondere darin, daß die Kennwerte der einzelnen Schaltungsteile, z.B. der Feldeffekttransistoren, große Toleranzen gegenüber vorgegebenen Sollwerten aufweisen können, ohne die Funktion der Schaltung zu beeinträchtigen. Daher können die einzelnen Schaltungsteile sehr unterschiedlichen Gegebenheiten bezüglich der Größe und Form der zu ihrer Realisierung zur Verfügung stehenden Halbleiterfläche angepaßt werden. Die stabilisierende Wirkung des beiden Invertern gemeinsamen Rückkopplungszweiges tritt immer nur dann in Erscheinung, wenn dem Schaltungsknoten ein zu speicherndes digitales Signal bereits zugeführt worden ist, wobei gleichzeitig der Schaltungseingang gegenüber diesem Knoten isoliert wird. Die Stabilisierung ist jedoch aufgehoben, solange dem Schaltungsknoten das zu speichernde digitale Signal zugeführt wird. Daher gelingt die Zwischenspeicherung auch bei großen Kennwertetoleranzen der einzelnen Schaltungsteile. Zur Taktung der erfindungsgemäßen Schaltung wird außerdem nur eine Taktspannung benötigt.

Die Patentansprüche 2 bis 6 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1 eine erste erfindungsgemäß ausgebildete Schaltung,

Fig. 2 den zeitlichen Verlauf einer in Fig. 1 verwendeten Taktspannung und

Fig. 3 eine erfindungsgemäße Schaltungsanordnung mit zwei Teilschaltungen, von denen die erste der Fig. 1 entspricht und die zweite durch gegenseitige Vertauschung zweier Feldeffekttransistoren aus Fig. 1 herleitbar ist.

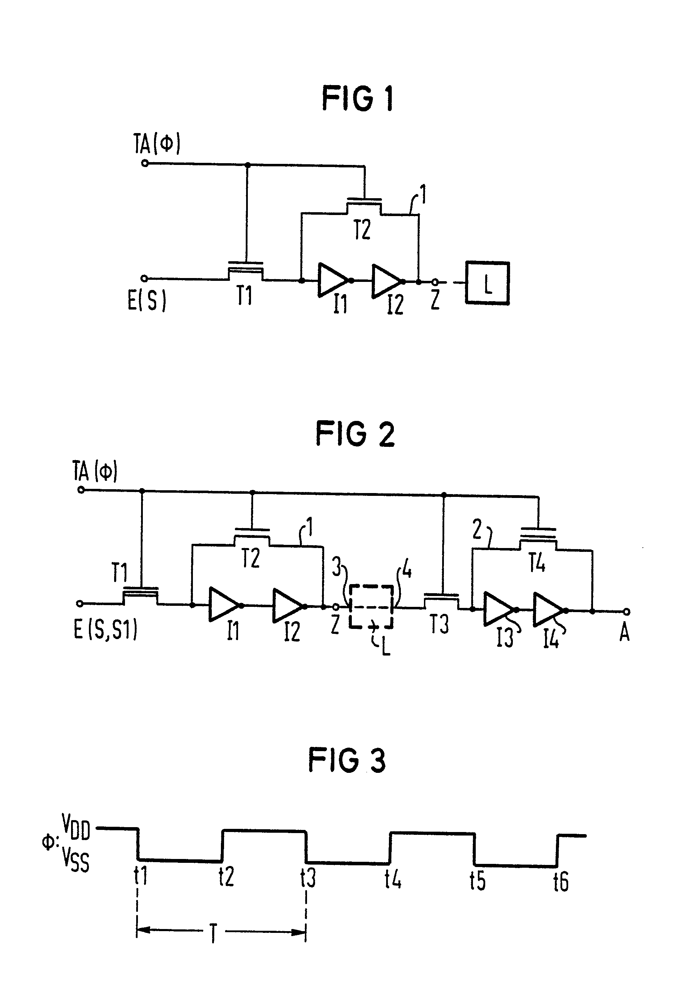

In Fig. 1 ist ein mit E bezeichneter Schaltungseingang über die Serienschaltung eines P-Kanal-Feldeffekttransistors T1 und zweier Inverter I1 und I2 mit einem Schaltungsknoten Z verbunden, an dem ein bei E anliegendes digitales Signal S zwischengespeichert werden soll. Der Ausgang des Inverters I2 ist über einen Rückkopplungszweig 1, in den ein N-Kanal-Feldeffekttransistor T2 eingefügt ist, mit dem Eingang des Inverters I1 verbunden. Die Gateelektroden der Feldeffekttransistoren T1 und T2 sind an einen gemeinsamen Taktspannungsanschluß TA gelegt, dem eine Taktspannung Ø zugeführt wird.

Gemäß Fig. 2 alterniert die Taktspannung Ø zwischen den Spannungswerten $V_{DD}$ und $V_{SS}$, wobei $V_{DD}$ z.B. +5 Volt beträgt, $V_{SS}$ üblicherweise 0 Volt. Sinkt die Amplitude von Ø zum Zeitpunkt t1 von $V_{DD}$ auf $V_{SS}$ ab, so wird der P-Kanal-Transistor T1 leitend, während der N-Kanal-Transistor T2 sperrt. Damit gelangt das bei E anliegende digitale Signal S über I1 und I2 auf den Schaltungsknoten Z. Der Rückkopplungszweig 1 ist hierbei wegen des gesperrten Transistors T2 unwirksam. Zum Zeitpunkt t2 steigt die Amplitude von Ø auf den Spannungswert $V_{SS}$ an, so daß T1 sperrt, während T2 leitet. Der nunmehr wirksam geschaltete Rückkopplungszweig 1 stabilisiert das am Schaltungsknoten Z liegende Signal S, das an Z abgegriffen und beispielsweise dem Eingang einer logischen Schaltung L zugeführt werden kann. Gleichzeitig wird Z über den gesperrten Transistor T1 vom Schaltungseingang E entkoppelt, so daß dieser mit einem neuen Signal belegt werden kann, ohne daß das an Z zwischengespeicherte Signal S hiervon beeinflußt wird. Zum Zeitpunkt t3 wird der Schaltungsknoten Z bei gesperrten Transistor T2 über den dann wieder leitend geschalteten Transistor T1 mit einem neuen, bei E anliegenden Signal S1 beaufschlagt, das während des Zeitabschnitts von t4 bis t5 seinerseits unter Wirksamschaltung des Rückkopplungszweiges 1 am Knoten Z zwischengespeichert bleibt und über Z an eine nachgeordnete Schaltung abgegeben werden kann, ohne daß es durch eine Signaländerung am Schaltungseingang E beeinflußt wird.

Fig. 3 zeigt eine erfindungsgemäße Schaltungsanordnung, die von der Schaltung nach Fig. 1 ausgeht und diese insoweit ergänzt, als der Schaltungsknoten Z über die Serienschaltung eines N-Kanal-Feldeffekttransistors T3 und zweier Inverter I3 und I4 mit einem weiteren Schaltungsknoten A verbunden ist, wobei die Inverter I3 und I4 einen gemeinsamen Rückkopplungszweig 2 aufweisen, in den ein P-Kanal-Feldeffekttransistor T4 eingefügt ist. Die Gateelektroden von T3 und T4 sind an den Anschluß TA geführt.

Legt man wieder die in Fig. 2 dargestellte Zeitabhängigkeit der Taktspannung Ø zugrunde, so wird der Schaltungsknoten Z während des Zeitintervalls t1 bis t2 mit einem bei E anliegenden Eingangssignal S beaufschlagt. Zwischen t2 und t3 wird das am Schaltungsknoten Z gespeicherte Signal durch Wirksamschaltung des Rückkopplungszweiges 1 stabilisiert, durch Sperrung von T1 gegenüber dem Schaltungseingang E entkoppelt und weiterhin durch Leitendschaltung von T3 über I3 und I4 an den weiteren Schaltungsknoten A übertragen. Dabei ist der Rückkopplungszweig 2 unwirksam, so daß diese Übertragung auch durch größere Kennwertetoleranzen der einzelnen Schaltungsteile nicht beeinträchtigt werden kann. Im Zeitraum zwischen t3 und t4 leiten die Transistoren T1 und T4, während T2 und T3 sperren. Dabei wird das an A liegende Signal S durch die Wirksamschaltung des Rückkopplungszweiges 2 stabilisiert und durch den gesperrten Transistor T3 vom Schaltungsknoten Z entkoppelt, so daß es über A an eine nachgeordnete Schaltung weitergegeben werden kann. Gleichzeitig wird der Schaltungsknoten Z bei gesperrtem Transistor T2 über den leitenden Transistor T1 mit einem neuen Eingangssignal S1 beaufschlagt. In der Zeitspanne zwischen t4 und t5 wird S1 am Schaltungsknoten Z über den leitenden Transistor T2 stabilisiert, durch den gesperrten Transistor T1 gegenüber E entkoppelt und über den leitenden Transistor T3 (bei gesperrtem Transistor T4) auf den weiteren Schaltungsknoten A übertragen. Zwischen t5 und t6 wird dann S1 über T4 stabilisiert, durch T3 gegenüber Z entkoppelt und über A an eine nachfolgende Schaltung abgegeben.

Hieraus ergibt sich, daß ein bei E anliegendes digitales Signal am weiteren Schaltungsknoten A der mit der Taktspannung Ø beaufschlagten Schaltungsanordnung nach Fig. 3 um eine Taktperiode T verzögert abgegriffen werden kann.

Wird die Taktspannung Ø z.B. zwischen t2 und t3 unterbrochen, so bleibt das Signal S am weiteren Schaltungsknoten A bei wirksam geschaltetem Rückkopplungskreis 2 gespeichert, während T3 sperrt. Beim Wiederanschalten von Ø (oder einer anderen, in ihrer Fre-

quenz von ∅ abweichenden Taktspannung) an den Anschluß TA laufen dann beim ersten Spannungsanstieg von $V_{SS}$ auf $V_{DD}$ die bereits beschriebenen, dem Zeitpunkt t4 zugeordneten Übertragungsvorgänge ab.

Eine Weiterbildung der Erfindung besteht darin, daß eine Mehrzahl von Schaltungsanordnungen nach Fig. 3 zu einer Gesamtschaltung zusammengesetzt sind. Dabei sind die einzelnen Schaltungsanordnungen nach Fig. 3 zueinander in Serie geschaltet, wobei der weitere Schaltungsknoten A einer jeden solchen Schaltungsanordnung mit dem Schaltungseingang E der jeweils nächstfolgenden verbunden ist. Bei einer Anzahl n von Schaltungsanordnungen nach Fig. 3 erfahren die eingangsseitig anliegenden digitalen Signale, z.B. S, beim Durchlaufen der Gesamtschaltung eine Verzögerung von $n \cdot T$.

Eine bevorzugte Anwendung der Schaltungsanordnung nach Fig. 3 ergibt sich, wenn zwischen dem Schaltungsknoten Z und dem Feldeffekttransistor T3 eine logische Schaltung L eingefügt wird, die einen Eingang 3 und einen Ausgang 4 aufweist. Hierbei wird ein bei E anliegendes Signal während der Zeitspanne t1 bis t2 an den Eingang 3 übertragen, und im Intervall t2 bis t3 gemäß der in dieser Schaltung realisierten logischen Funktion verarbeitet.

Das am Ausgang 4 anfallende Verarbeitungsergebnis gelangt noch vor dem Zeitpunkt t3 zum weiteren Schaltungsknoten A und wird während des Intervalls t3 bis t4 durch Wirksamschaltung des Rückkopplungszweiges 2 bei A stabilisiert, durch T3 von L entkoppelt und über A an eine nachfolgende Schaltung abgegeben.

Mit Vorteil können auch mehrere nach Fig. 3 ausgebildete, in der beschriebenen Weise mit einer logischen Schaltung L verbundene Schaltungsanordnungen zu einer Gesamtschaltung zusammengesetzt sein. Dabei ist der weitere Schaltungsknoten A einer jeden solchen Schaltungsanordnung mit dem Schaltungseingang E der jeweils nächstfolgenden verbunden. Eine weitere Ausgestaltung der Erfindung besteht darin, daß bei der zuletzt beschriebenen Gesamtschaltung auch zwischen dem weiteren Schaltungsknoten A einer jeden solchen Schaltungsanordnung und dem Schaltungseingang E der nächstfolgenden eine logische Schaltung eingefügt ist. Andererseits kann auch ausgehend von der zuletzt beschriebenen Ausgestaltung der Erfindung eine andere Ausgstaltung dadurch abgeleitet werden, daß die zwischen dem Schaltungsknoten Z und den Feldeffekttransistoren T3 der einzelnen Schaltungsanordnungen liegenden logischen Schaltungen L jeweils entfallen.

Vertauscht man in den obigen Schaltungen die Feldeffekttransistoren des einen Kanaltyps, z.B. T1 und T4, mit denen des anderen Kanaltyps, z.B. T2 und T3, so vertauschen sich auch die Signalübertragungsvorgänge während der $V_{SS}$-Phase und der $V_{DD}$-Phase von ∅ entsprechend.

## Ansprüche

1. Schaltung zur Zwischenspeicherung digitaler Signale in komplementärer integrierter Schaltungstechnik, **dadurch gekennzeichnet**, daß ein Schaltungseingang (E) über die Serienschaltung eines Feldeffekttransistors (T1) des ersten Kanaltyps und zweier Inverter (I1, I2) mit einem Schaltungsknoten (Z) verbunden ist, daß beide Inverter (I1, I2) mit einem gemeinsamen Rückkopplungszweig (1) versehen sind, der einen Feldeffekttransistor (T2) des zweiten Kanaltyps enthält, und daß die Gateelektroden beider Feldeffekttransistoren (T1, T2) mit einem gemeinsamen Taktspannungsanschluß (TA) beschaltet sind.

2. Schaltung nach Anspruch 1, **dadurch gekennzeichnet**, daß der Schaltungsknoten (Z) mit dem Eingang (3) einer logischen Schaltung (L) verbunden ist.

3. Schaltung nach Anspruch 1, **dadurch gekennzeichnet**, daß der Schaltungsknoten (Z) über die Serienschaltung eines weiteren Feldeffekttransistors (T3) des zweiten Kanaltyps und zweier weiterer Inverter (I3, I4) mit einem weiteren Schaltungsknoten (A) verbunden ist, daß die beiden weiteren Inverter (I3, I4) mit einem weiteren gemeinsamen Rückkopplungszweig (2) versehen sind, der einen weiteren Feldeffekttransistor (T4) des ersten Kanaltyps enthält, und daß die Gateelektroden der weiteren Feldeffekttransistoren (T3, T4) an den gemeinsamen Taktspannungsanschluß (TA) gelegt sind.

4. Schaltung nach Anspruch 3, **dadurch gekennzeichnet**, daß zwischen dem Schaltungsknoten (Z) und dem weiteren Feldeffekttransistor (T3) des zweiten Kanaltyps eine logische Schaltung (L) eingefügt ist.

5. Schaltungsanordnung zur Zwischenspeicherung digitaler Signale, **gekennzeichnet durch** eine Mehrzahl von Schaltungen nach Anspruch 3 oder 4, wobei jeweils der weitere Schaltungsknoten (A) einer solchen Schaltung mit dem Schaltungseingang (E) der nächstfolgenden solchen Schaltung verbunden ist und die Gateelektroden der genannten Feldeffekttransistoren (T1 bis T4) aller dieser Schaltungen mit einem allen gemeinsamen Taktspannungsanschluß (TA) verbunden sind.

6. Schaltungsanordnung zur Zwischenspeicherung digitaler Signale nach Anspruch 5, **dadurch gekennzeichnet**, daß zwischen dem weiteren Schaltungsknoten (A) einer solchen Schaltung und dem Schaltungseingang (E) der nächstfolgenden Schaltung eine weitere logische Schaltung eingefügt ist.

# FIG 1

# FIG 2

# FIG 3